# EUROPÄISCHE PATENTANMELDUNG

(11) **EP 4 074 611 A1**
(43) Veröffentlichungstag der Anmeldung: **19.10.2022**
(21) Anmeldenummer: 21168571.4
(22) Anmeldetag: 15.04.2021
(51) Int. Cl.: B65B 7/28, A45C 11/00, B65B 25/00, B65D 75/30, B65D 75/32, B65D 81/22

(54) **KONTAKTLINSENVERPACKUNG SOWIE VERFAHREN UND VERPACKUNGSMASCHINE ZUR HERSTELLUNG DERSELBEN**

(71) Anmelder: KOCH Pac-Systeme GmbH, 72285 Pfalzgrafenweiler (DE)
(72) Erfinder: KAPPLER, Karl, 72297 Seewald (DE); BITZER, Jürgen, 72160 Horb (DE); DOELKER, Benjamin, 72280 Dornstetten (DE)
(74) Vertreter: Wächter, Jochen

(57) **Zusammenfassung**

Die Kontaktlinsenverpackung (2) umfasst ein Aufnahmeelement (4) mit einem Napf (2), der ein Kontaktlinsenfluid (12) und eine Kontaktlinse (14) enthält, und eine Deckfolie (8), die den Napf (6) verschließt. Das Aufnahmeelement (4) weist zumindest im Bereich des Napfs (6) eine Beschichtung (16) auf, die Siliziumoxid oder Aluminiumoxid enthält. Das zugehörige Herstellverfahren umfasst das Beschichten des Aufnahmeelements (4) zumindest im Bereich des Napfs (6) mit der Beschichtung (16) und die zugehörige Verpackungsmaschine (32) umfasst eine Beschichtungsstation (44) zum entsprechenden Beschichten des Aufnahmeelements (4).

## Beschreibung

Die vorliegende Erfindung betrifft eine Kontaktlinsenverpackung sowie ein Verfahren und eine Verpackungsmaschine zur Herstellung derselben.

Kontaktlinsenverpackungen umfassen in der Regel ein Aufnahmeelement mit zumindest einem Napf, in dem ein Kontaktlinsenfluid und eine Kontaktlinse enthalten sind, sowie eine Deckfolie, die fest mit dem Aufnahmeelement verbunden ist, um den zumindest einen Napf dicht zu verschließen. Das Kontaktlinsenfluid ist beispielsweise eine Kochsalzlösung, die die Kontaktlinse elastisch, feucht und steril hält.

Eine Diffusion des Kontaktlinsenfluids bzw. von Bestandteilen davon aus der Kontaktlinsenverpackung würde zu einer Konzentrationsänderung des verbleibenden Kontaktlinsenfluids in der Kontaktlinsenverpackung führen und dadurch die Haltbarkeit der verpackten Kontaktlinse beeinflussen. Um dies zu vermeiden und eine ausreichend lange Haltbarkeit der verpackten Kontaktlinse zu gewährleisten, müssen Kontaktlinsenverpackungen eine ausreichende Barrierewirkung aufweisen.

Die Barrierewirkung kann beispielsweise dadurch erreicht werden, dass das Aufnahmeelement aus einem mehrlagigen Kunststofffolienverbund gebildet ist. Derartige Aufnahmeelemente sind jedoch teuer und aufwendig in der Herstellung und lassen sich nur schlecht recyceln.

Üblicherweise werden Aufnahmeelemente von Kontaktlinsenverpackungen daher mittels Spritzguss hergestellt und weisen eine relativ große Wandstärke von z.B. 0,8 mm bis 1 mm auf, um die erforderliche Barrierewirkung bereitzustellen. Insbesondere bei sehr großen Stückzahlen sind der Materialbedarf und die dadurch bedingten Materialkosten folglich enorm.

Es ist eine Aufgabe der vorliegenden Erfindung, ein Verfahren und eine Verpackungsmaschine zur Herstellung von Kontaktlinsenverpackungen sowie Kontaktlinsenverpackungen bereitzustellen, die eine kostengünstige Herstellung von Kontaktlinsenverpackungen mit ausreichender Barrierewirkung ermöglichen.

Diese Aufgabe wird durch den Gegenstand der unabhängigen Ansprüche 1, 11 und 14 gelöst. Bevorzugte Ausführungsformen sind Gegenstand der jeweils abhängigen Ansprüche.

Ein erfindungsgemäßes Verfahren zur Herstellung von Kontaktlinsenverpackungen umfasst die folgenden Schritte:
Bilden eines Aufnahmeelements, das zumindest einen Napf aufweist;
Beschichten des Aufnahmeelements zumindest im Bereich des zumindest einen Napfs mit einer Beschichtung, die Siliziumoxid oder Aluminiumoxid enthält;
Füllen des zumindest einen Napfs mit einem Kontaktlinsenfluid und einer Kontaktlinse; und
Aufbringen einer Deckfolie auf das Aufnahmeelement zum Verschließen des zumindest einen Napfs.

Auf diese Weise wird eine Kontaktlinsenverpackung hergestellt, die zumindest im Bereich des Napfs, der das Kontaktlinsenfluid aufnimmt, eine Beschichtung mit Siliziumoxid oder Aluminiumoxid aufweist. Die Beschichtung ist dazu ausgebildet, das Aufnahmeelement im Bereich des Napfs abzudichten. Die Siliziumoxid oder Aluminiumoxid enthaltende Beschichtung weist ausgezeichnete Barriereeigenschaften auf, die eine Diffusion des Kontaktlinsenfluids bzw. von Bestandteilen desselben stark reduziert oder gar eliminiert. Dadurch kann die Wandstärke der Kontaktlinsenverpackung deutlich reduziert werden, zum Beispiel auf etwa ein Drittel der Wandstärke herkömmlicher Kontaktlinsenverpackungen, wodurch sich der Materialbedarf und somit die Kosten drastisch verringern lassen. Im Vergleich zu einem mehrlagigen Kunststofffolienverbund sind die Kontaktlinsenverpackungen auch besser zu recyceln. Sowohl der reduzierte Materialbedarf als auch die bessere Recyclingfähigkeit sind zudem ökologisch vorteilhaft.

Das Siliziumoxid kann insbesondere Siliziummonoxid oder Siliziumdioxid umfassen. In einer bevorzugten Ausführungsform besteht die Beschichtung ausschließlich aus Siliziumoxid, insbesondere aus Siliziumdioxid. Zumindest bildet das Siliziumoxid einen wesentlichen Bestandteil der Beschichtung, um die erforderliche Barrierewirkung der Beschichtung bereitzustellen.

Das Aluminiumoxid kann insbesondere Al₂O₃ umfassen. In einer bevorzugten Ausführungsform besteht die Beschichtung ausschließlich aus Aluminiumoxid. Zumindest bildet das Aluminiumoxid einen wesentlichen Bestandteil der Beschichtung, um die erforderliche Barrierewirkung der Beschichtung bereitzustellen.

Das Kontaktlinsenfluid ist bevorzugt eine Kochsalzlösung umfassend Wasser und Natriumchlorid. Es kann sich aber auch um ein anderes bekanntes Kontaktlinsenfluid handeln.

Bevorzugt erfolgen die hierin beschriebenen Verfahrensschritte aller Ausführungsformen jeweils in der angegebenen Reihenfolge. Unabhängig davon werden bevorzugt alle hierin beschriebenen Verfahrensschritte automatisch, d.h. maschinell, ausgeführt. So erfolgt beispielsweise das Bilden des Aufnahmeelements mittels einer Formstation, das Beschichten des Aufnahmeelements mittels einer Beschichtungsstation, das Füllen des Napfs mittels einer Füllstation und das Aufbringen der Deckfolie mittels einer Siegelstation einer Verpackungsmaschine.

Die Effizienz des Verfahrens kann dadurch erhöht werden, dass das Verfahren jeweils für eine Mehrzahl von Aufnahmeelementen ausgeführt wird. Anstelle des einen Aufnahmeelements tritt dann jeweils die Mehrzahl von Aufnahmeelementen, von der das eine Aufnahmeelement umfasst ist. Hierzu kann jeder Verfahrensschritt gleichzeitig für die Mehrzahl von Aufnahmeelementen ausgeführt werden. Die Verfahrensschritte können auch für jedes Aufnahmeelement oder für jeweils eine Mehrzahl von Aufnahmeelementen wiederholt werden. Dies gilt für alle hierin beschriebenen Ausführungsformen des Verfahrens.

Unabhängig davon kann das Aufnahmeelement eine Mehrzahl von Näpfen aufweisen. Beispielsweise weist das Aufnahmeelement zwei Näpfe auf, von denen einer eine Kontaktlinse für das linke Auge und der andere eine Kontaktlinse für das rechte Auge enthalten kann. Das Aufnahmeelement kann auch mehr als zwei Näpfe aufweisen, die zum Beispiel jeweils eine Kontaktlinse derselben Stärke enthalten können.

Das Beschichten des Aufnahmeelements im Bereich des zumindest einen Napfs umfasst das Beschichten zumindest der Napfinnenseite. Die Napfinnenseite ist die Seite des Napfs, die zusammen mit der Deckfolie einen Hohlraum bildet, in dem das Kontaktlinsenfluid und die Kontaktlinse aufgenommen werden. Die Napfinnenseite steht daher in Kontakt mit dem Kontaktlinsenfluid. Bevorzugt ist die Napfinnenseite des zumindest einen Napfs vollständig mit der Beschichtung beschichtet.

Das Aufnahmeelement umfasst zudem einen Flansch, der den zumindest einen Napf umgibt. Das Aufbringen der Deckfolie umfasst vorzugsweise das Befestigen der Deckfolie an dem Flansch, insbesondere das (Heiß-) Siegeln oder Kleben der Deckfolie an den Flansch. Dadurch kann die Deckfolie vollständig um den zumindest einen Napf dichtend mit dem Aufnahmeelement verbunden werden.

Es kann gewünscht sein, dass Bereiche außerhalb des Napfs und insbesondere der Bereich des Flansches, in dem die Deckfolie aufgebracht wird, nicht beschichtet werden, um eine einfachere und bessere Verbindung der Deckfolie mit dem Aufnahmeelement zu ermöglichen. Das Beschichten des Aufnahmeelements erfolgt dann vorzugsweise ausschließlich im Bereich des Napfs, insbesondere ausschließlich auf der Napfinnenseite.

Während Aufnahmeelemente von Kontaktlinsenverpackungen aufgrund der großen Wandstärke bislang üblicherweise mittels Spritzguss gebildet wurden, ist es durch das erfindungsgemäße Verfahren und die dadurch realisierbare geringere Wandstärke nun erstmals möglich, Aufnahmeelemente von Kontaktlinsenverpackungen durch Thermoformen aus einer vorzugsweise einlagigen Folienbahn herzustellen.

In einer bevorzugten Ausführungsform umfasst das Bilden des Aufnahmeelements daher die folgenden Schritte:
Bereitstellen einer Folienbahn; und
Thermoformen des mindestens einen Napfs in die Folienbahn.

Das Thermoformen umfasst vorzugsweise das Erwärmen der Folienbahn und das Tiefziehen des zumindest einen Napfs in der erwärmten Folienbahn. Das Tiefziehen kann mittels einer Formvorrichtung und/oder Druckluft oder Vakuum erfolgen. Die Formvorrichtung kann einen Stempel und eine Matrize aufweisen und, falls gewünscht, durch die Anwendung von Druckluft oder Vakuum unterstützt werden. Die Formvorrichtung kann auch nur eine Matrize aufweisen, in die die Folienbahn mittels Druckluft oder Vakuum eingeformt wird.

Durch den Einsatz der Siliziumoxid oder Aluminiumoxid enthaltenden Beschichtung kann das Aufnahmeelement der Kontaktlinsenverpackung aus einer verhältnismäßig dünnen Folie gebildet werden. Es ist bevorzugt, dass das Aufnahmeelement zumindest im Bereich des zumindest einen Napfs eine Wandstärke aufweist, die zwischen 0,05 mm und 0,6 mm, mehr bevorzugt zwischen 0,1 mm und 0,5 mm, noch mehr bevorzugt zwischen 0,2 mm und 0,4 mm beträgt.

Im Falle des Thermoformens weist die Folienbahn vorzugsweise eine Dicke auf, die zwischen 0,05 mm und 0,6 mm, mehr bevorzugt zwischen 0,1 mm und 0,5 mm, noch mehr bevorzugt zwischen 0,2 mm und 0,4 mm beträgt.

Das Aufnahmeelement und somit die gegebenenfalls verwendete Folienbahn ist bevorzugt aus einem Kunststoff gebildet, der aus der Gruppe der Polyolefine oder der Polyhalogenolefine gewählt ist, oder aus einer Kombination daraus. Besonders bevorzugt ist der Kunststoff aus einer Gruppe gewählt, die umfasst: Polypropylen (PP), Polyvinylchlorid (PVC), Polyethylen (PE), Polyamid (PA) oder Polyethylenterephthalat (PET). Bevorzugt umfasst das Aufnahmeelement und somit die gegebenenfalls verwendete Folienbahn ausschließlich eine Schicht aus dem jeweiligen Kunststoff und insbesondere kein Verbundmaterial bzw. keinen mehrlagigen Aufbau aus unterschiedlichen Materialien.

Vorzugsweise umfasst das Bilden des Aufnahmeelements weiterhin das Stanzen des Aufnahmeelements aus der Folienbahn vor dem Beschichten des Aufnahmeelements. Dadurch kann sichergestellt werden, dass die Beschichtung beim Stanzen nicht beschädigt oder zerstört wird. Es ist aber auch denkbar, dass das Verfahren das Stanzen des Aufnahmeelements aus der Folienbahn nach dem Beschichten des Aufnahmeelements umfasst.

Das Stanzen erfolgt vorzugsweise mittels einer Stanzvorrichtung. Beim Stanzen wird das Aufnahmeelement vollständig aus der Folienbahn heraus getrennt. Es ist aber auch denkbar, eine Mehrzahl von miteinander verbundenen bzw. einstückig ausgebildeten Aufnahmeelementen auszustanzen.

Um das Verfahren möglichst effizient zu gestalten und das Beschichten zu erleichtern, umfasst das Verfahren vor dem Beschichten des Aufnahmeelements bevorzugt weiterhin die Schritte:
Erfassen des Aufnahmeelements mittels einer Handhabungsvorrichtung; und
Einsetzen des erfassten Aufnahmeelements in einen Träger mittels der Handhabungsvorrichtung.

Dies hat den Vorteil, dass mehrere Aufnahmeelemente weiterhin vereinzelt und nicht im Bulk verarbeitet werden, was bei Aufnahmeelementen mit einer Wandstärke von beispielsweise 0,3 mm zu Beschädigungen derselben führen könnte. Zudem kann die Übergabe der Aufnahmeelemente zum Beschichten dadurch automatisiert erfolgen. Der Träger kann vorzugsweise eine Mehrzahl von Aufnahmeelementen aufnehmen.

Im Fall des Thermoformens erfolgt das Erfassen und Einsetzen des Aufnahmeelements vorzugsweise nach dem Stanzen. Insbesondere können die Aufnahmeelemente dann mittels der Handhabungsvorrichtung in der Stanzvorrichtung erfasst und aus der Stanzvorrichtung entnommen werden.

Die Handhabungsvorrichtung kann als Greifeinrichtung oder als Saugeinrichtung ausgebildet sein. Entsprechende Vorrichtungen sind dem Fachmann auch als "Pick and Place"-Vorrichtungen oder Bestückungsvorrichtungen bekannt.

Geeignete Rahmenbedingungen zum Beschichten des Aufnahmeelements können geschaffen werden, wenn das Verfahren vor dem Beschichten des Aufnahmeelements weiterhin das Anordnen des Aufnahmeelements in einer Beschichtungskammer umfasst und das Beschichten des Aufnahmeelements in der Beschichtungskammer erfolgt. In der Beschichtungskammer können die Rahmenbedingungen, wie zum Beispiel der Druck und die das Aufnahmeelement umgebende Atmosphäre, besonders gut beeinflusst und eingestellt werden.

Zum Bewegen des Aufnahmeelements in die Beschichtungskammer kann die Beschichtungskammer vorzugsweise geöffnet und geschlossen werden. Zum Beispiel weist die Beschichtungskammer hierzu mindestens eine, vorzugsweise zwei verschließbare Öffnungen auf, durch die das Aufnahmeelement in die Beschichtungskammer hinein und aus der Beschichtungskammer heraus bewegt werden kann. Es ist auch denkbar, dass ein Teil der Beschichtungskammer beweglich ausgebildet ist und zum Beispiel über das Aufnahmeelement bewegt wird.

Das Anordnen des Aufnahmeelements in der Beschichtungskammer umfasst bevorzugt das Bewegen des Trägers, in den das Aufnahmeelement eingesetzt ist, in die Beschichtungskammer. Vorzugsweise ist in den Träger eine Mehrzahl von Aufnahmeelementen eingesetzt.

Das Beschichten des Aufnahmeelements bzw. das Erzeugen der Beschichtung kann mittels physikalischer Gasphasenabscheidung erfolgen.

Das Beschichten des Aufnahmeelements bzw. das Erzeugen der Beschichtung kann aber auch mittels chemischer Gasphasenabscheidung erfolgen. In einer Ausführungsform erfolgt das Beschichten des Aufnahmeelements bzw. das Erzeugen der Beschichtung bevorzugt durch das PECVD (Plasma Enhanced Chemical Vapor Deposition) -Verfahren oder das PICVD (Plasma Impuls Chemical Vapor Deposition) -Verfahren. Diese Verfahren haben den Vorteil, dass sie das Bilden sehr dünner und sehr gleichmäßiger Beschichtungen auch auf gekrümmten Substraten, wie dem Aufnahmeelement mit dem zumindest einen Napf, mit hoher Qualität ermöglichen. Zu Details zum PECVD-Verfahren und zum PICVD-Verfahren wird beispielhaft verwiesen auf "Unger, E. (1991), Die Erzeugung dünner Schichten. Das PECVD-Verfahren: Gasphasenabscheidung in einem Plasma, in Chemie in unserer Zeit, Vol. 25, Ausgabe 3" sowie "Bach et al. (2003), Thin Films on Glass, Deutschland, Springer Berlin Heidelberg".

Das Verfahren umfasst vorzugsweise nach dem Anordnen des Aufnahmeelements in der Beschichtungskammer und vor dem Beschichten des Aufnahmeelements weiterhin die Schritte:
Erzeugen eines Unterdrucks in der Beschichtungskammer; und
Einführen eines Prozessgases in die Beschichtungskammer.

Der Unterdruck beträgt vorzugsweise zwischen 1*10⁻² und 1*10⁻⁸ mbar, mehr bevorzugt zwischen 2*10⁻⁴ und 1*10⁻⁷ mbar, noch mehr bevorzugt zwischen 2*10⁻⁵ und 1*10⁻⁶ mbar.

Das Prozessgas enthält vorzugsweise Sauerstoff und ein silizium- oder aluminiumhaltiges Gas. Das Prozessgas kann z.B. Monosilan SiH₄, Stickstoffmonoxid NO und/oder Tetraethylorthosilicat Si(OC₂H₅)₄ umfassen.

Das Beschichten des Aufnahmeelements umfasst dann bevorzugt das Erzeugen eines Plasmas in der Beschichtungskammer und dadurch das Erzeugen der Beschichtung. Das Plasma kann in der Beschichtungskammer unter Energiezufuhr mittels Mikrowellenstrahlung oder mittels Elektroden erzeugt werden.

Eine beispielhafte Reaktion, die zur Erzeugung einer Siliziumoxid enthaltenden Beschichtung stattfinden kann, ist

SiH₄ + 4NO → SiO₂ + 2H₂O + 2N₂

wobei SiH₄ und NO gasförmig zugeführt werden und Siliziumdioxid SiO₂ entsteht.

Bereits eine sehr dünne Siliziumoxid oder Aluminiumoxid enthaltende Beschichtung reicht aus, um die erforderliche Barrierewirkung zu erzielen. Vorzugsweise weist die Beschichtung eine Schichtdicke auf, die zwischen 2 nm und 500 nm, mehr bevorzugt zwischen 10 nm und 250 nm, noch mehr bevorzugt zwischen 20 nm und 80 nm beträgt. In einer besonders bevorzugten Ausführungsform beträgt die Schichtdicke der Beschichtung zwischen 40 nm und 60 mn oder zwischen 45 nm und 55 nm. Beschichtungen einer solchen Dicke können gut mit den genannten Verfahren erzeugt werden.

Vorzugsweise ist das Aufnahmeelement während des Beschichtens in dem Träger aufgenommen. Wie oben beschrieben, wurde das Aufnahmeelement bevorzugt mittels des Trägers in die Beschichtungskammer bewegt. Um das Verfahren möglichst effizient zu gestalten, ist es weiterhin bevorzugt, dass das Füllen des zumindest einen Napfs des Aufnahmeelements das Bewegen des Trägers durch eine Füllstation umfasst und dass das Aufbringen der Deckfolie auf das Aufnahmeelement das Bewegen des Trägers durch eine Siegelstation umfasst. Infolgedessen wird das Aufnahmeelement in dem Träger durch weitere Bearbeitungsstationen bewegt, ohne dass eine Handhabung oder ein Umsetzen der filigranen Aufnahmeelemente erforderlich ist. Zudem sind die Aufnahmeelemente dadurch zu keinem Zeitpunkt des Verfahrens im Bulk angeordnet, sodass der aufwändige Schritt der Vereinzelung der Aufnahmeelemente vor dem Füllen und dem Verschließen der Aufnahmeelemente eliminiert wird, der bei spritzgegossenen Aufnahmeelementen üblicherweise notwendig ist.

Weist das Aufnahmeelement eine Mehrzahl von Näpfen auf und/oder sind mehrere Aufnahmeelemente miteinander verbunden ausgebildet, kann es gewünscht sein, einzelne Näpfe bzw. Aufnahmeelemente abtrennen zu können. Ist die Deckfolie auf das Aufnahmeelement aufgebracht, kann das Verfahren dann weiterhin das Einbringen einer Materialschwächung, insbesondere einer Perforation oder Rille, zwischen den einzelnen Näpfen eines Aufnahmeelements bzw. den einzelnen Aufnahmeelementen umfassen.

Insgesamt wird somit ein sehr effizientes Verfahren zur Herstellung kostengünstiger Kontaktlinsenverpackungen bereitgestellt.

Eine erfindungsgemäße Kontaktlinsenverpackung umfasst ein Aufnahmeelement, das zumindest einen Napf zur Aufnahme eines Kontaktlinsenfluids und einer Kontaktlinse aufweist, und eine Deckfolie, die mit dem Aufnahmeelement verbunden ist, um den zumindest einen Napf zu verschließen. Das Aufnahmeelement weist zumindest im Bereich des zumindest einen Napfs eine Beschichtung auf, die Siliziumoxid oder Aluminiumoxid enthält.

Auf diese Art und Weise wird eine Kontaktlinsenverpackung bereitgestellt, die zumindest im Bereich des Napfs, der das Kontaktlinsenfluid aufnimmt, eine Beschichtung mit Siliziumoxid oder Aluminiumoxid aufweist. Die Beschichtung ist dazu ausgebildet, das Aufnahmeelement im Bereich des Napfs abzudichten. Die Siliziumoxid oder Aluminiumoxid enthaltende Beschichtung weist ausgezeichnete Barriereeigenschaften auf, die eine Diffusion des Kontaktlinsenfluids bzw. von Bestandteilen desselben stark reduziert oder gar eliminiert. Dadurch kann die Wandstärke der Kontaktlinsenverpackung deutlich reduziert werden, zum Beispiel auf etwa ein Drittel der Wandstärke herkömmlicher Kontaktlinsenverpackungen, wodurch sich der Materialbedarf und somit die Kosten drastisch verringern lassen. Im Vergleich zu einem mehrlagigen Kunststofffolienverbund sind die Kontaktlinsenverpackungen auch besser zu recyceln. Sowohl der reduzierte Materialbedarf als auch die bessere Recyclingfähigkeit sind ökologisch vorteilhaft.

Die erfindungsgemäße Kontaktlinsenverpackung ist bevorzugt mittels des zuvor beschriebenen erfindungsgemäßen Verfahrens gestellt.

Alle bezüglich der Kontaktlinsenverpackung und insbesondere der Beschichtung im Zusammenhang mit dem erfindungsgemäßen Verfahren beschriebenen Merkmale sind analog auf die erfindungsgemäße Kontaktlinsenverpackung übertragbar und umgekehrt.

Der zumindest eine Napf enthält das Kontaktlinsenfluid und eine Kontaktlinse. Das Kontaktlinsenfluid ist bevorzugt eine Kochsalzlösung umfassend Wasser und Natriumchlorid. Es kann sich aber auch um ein anderes bekanntes Kontaktlinsenfluid handeln.

Die Kontaktlinsenverpackung kann auch eine Mehrzahl von miteinander verbundenen Aufnahmeelementen umfassen.

Das Aufnahmeelement kann eine Mehrzahl von Näpfen aufweisen. Beispielsweise weist das Aufnahmeelement zwei Näpfe auf, von denen einer eine Kontaktlinse für das linke Auge und der andere eine Kontaktlinse für das rechte Auge enthalten kann. Das Aufnahmeelement kann auch zwei oder mehr Näpfe aufweisen, die zum Beispiel jeweils eine Kontaktlinse derselben Stärke enthalten können.

Der zumindest eine Napf weist vorzugsweise einen Durchmesser auf, der zwischen 5 mm und 35 mm, mehr bevorzugt zwischen 18 mm und 28 mm, noch mehr bevorzugt zwischen 20 mm und 22 mm beträgt.

Eine Tiefe des zumindest einen Napfs beträgt vorzugsweise zwischen 1 mm und 15 mm, mehr bevorzugt zwischen 3 mm und 10 mm, noch mehr bevorzugt zwischen 5 mm und 6 mm.

Bevorzugt weist zumindest eine Napfinnenseite der zumindest einen Napfs die Beschichtung auf. Die Napfinnenseite ist die Seite des Napfs, die zusammen mit der Deckfolie einen Hohlraum bildet, in dem das Kontaktlinsenfluid und die Kontaktlinse aufgenommen sind. Die Napfinnenseite steht daher in Kontakt mit dem Kontaktlinsenfluid. Bevorzugt ist die Napfinnenseite vollständig mit der Beschichtung beschichtet.

Das Aufnahmeelement umfasst zudem den Flansch, der den zumindest einen Napf umgibt. Die Deckfolie ist vorzugsweise an dem Flansch befestigt, insbesondere an den Flansch (heiß-) gesiegelt oder geklebt. Idealerweise ist die Deckfolie vollständig um den zumindest einen Napf herum dichtend mit dem Aufnahmeelement verbunden.

Es ist denkbar, dass Bereiche außerhalb des Napfs und insbesondere der Bereich des Flansches, in dem die Deckfolie aufgebracht wird, keine Beschichtung aufweisen. Dadurch kann eine einfachere und bessere Verbindung der Deckfolie mit dem Aufnahmeelement ermöglicht werden. Vorzugsweise weist dann ausschließlich der Bereich des Napfs, insbesondere ausschließlich die Napfinnenseite die Beschichtung auf.

Um eine ausreichende Dichtheit der Kontaktlinsenverpackung zu gewährleisten und ein einfaches Verbinden der Deckfolie mit dem Aufnahmeelement sowie ein einfaches Öffnen der Kontaktlinsenverpackung durch Entfernen der Deckfolie zu ermöglichen, kann die Deckfolie durch eine Aluminium-Verbundfolie gebildet sein. Zum Bespiel umfasst eine solche Verbundfolie jeweils eine Schicht aus Polypropylen PP, Aluminium und Polyethylen PE. Unabhängig vom Aufbau der Deckschicht und von diesen Materialen ist auch denkbar, dass die Deckfolie eine Beschichtung aufweist, die Siliziumoxid oder Aluminiumoxid enthält. Insbesondere weist dann eine dem zumindest einen Napf zugewandte Seite der Deckfolie die Beschichtung auf. Im Übrigen wird auf die Ausführungen zur Beschichtung des Aufnahmeelements verwiesen, die analog zutreffen.

Große Materialeinsparungen können erzielt werden, wenn das Aufnahmeelement im Bereich des zumindest einen Napfs vorzugsweise eine Wandstärke aufweist, die zwischen 0,05 mm und 0,6 mm, mehr bevorzugt zwischen 0,1 mm und 0,5 mm, noch mehr bevorzugt zwischen 0,2 mm und 0,4 mm beträgt.

Das Aufnahmeelement ist bevorzugt aus einem Kunststoff gebildet, der aus der Gruppe der Polyolefine oder der Polyhalogenolefine gewählt ist, oder aus einer Kombination daraus. Besonders bevorzugt ist der Kunststoff aus einer Gruppe gewählt, die umfasst: Polypropylen (PP), Polyvinylchlorid (PVC), Polyethylen (PE), Polyamid (PA) oder Polyethylenterephthalat (PET).

Vorzugsweise weist die Beschichtung eine Schichtdicke auf, die zwischen 2 nm und 500 nm, mehr bevorzugt zwischen 10 nm und 250 nm, noch mehr bevorzugt zwischen 20 nm und 80 nm beträgt. In einer besonders bevorzugten Ausführungsform beträgt die Schichtdicke der Beschichtung zwischen 40 nm und 60 mn oder zwischen 45 nm und 55 nm. Beschichtungen einer solchen Dicke können gut mit den hierin beschriebenen Verfahren erzeugt werden.

Eine erfindungsgemäße Verpackungsmaschine zum Herstellen von Kontaktlinsenverpackungen umfasst:
eine Formstation, die dazu ausgebildet ist, zumindest einen Napf in einem Aufnahmeelement zu bilden;
eine Beschichtungsstation, die dazu ausgebildet ist, das Aufnahmeelement zumindest im Bereich des zumindest einen Napfs mit einer Beschichtung zu beschichten, die Siliziumoxid oder Aluminiumoxid enthält;
eine Füllstation, die dazu ausgebildet ist, den zumindest einen Napf des Aufnahmeelements mit einem Kontaktlinsenfluid und einer Kontaktlinse zu befüllen; und
eine Siegelstation, die dazu ausgebildet ist, eine Deckfolie auf das Aufnahmeelement zum Verschließen des zumindest einen Napfs aufzubringen.

Auf diese Art und Weise wird eine Verpackungsmaschine bereitgestellt, mit der es möglich ist, den zumindest einen Napf des Aufnahmeelements der Kontaktlinsenverpackung mit einer Siliziumoxid oder Aluminiumoxid enthaltenen Beschichtung zu versehen und dadurch die bereits zum erfindungsgemäßen Verfahren und zur erfindungsgemäßen Kontaktlinsenverpackung beschriebenen Vorteile zu erreichen.

Bevorzugt ist die Verpackungsmaschine zum Ausführen des erfindungsgemäßen Verfahrens ausgebildet. Vorzugsweise ist die Verpackungsmaschine zum Herstellen von erfindungsgemäßen Kontaktlinsenverpackungen ausgebildet.

Die unter Bezug auf das erfindungsgemäße Verfahren oder die erfindungsgemäße Kontaktlinsenverpackung beschriebenen Merkmale sind analog auf die erfindungsgemäße Verpackungsmaschine übertragbar und umgekehrt.

Die Verpackungsmaschine kann weiterhin eine Stanzstation umfassen, die dazu ausgebildet ist, das Aufnahmeelement auszustanzen. Insbesondere kann die Formstation zum Thermoformen des zumindest einen Napfs in eine Folienbahn ausgebildet sein und die Stanzstation zum Stanzen des Aufnahmeelements aus der Folienbahn ausgebildet sein. Die Verpackungsmaschine kann nach der Siegelstation eine weitere Station, wie z.B. eine Perforier- oder Rillstation, umfassen, die dazu ausgebildet ist, eine Materialschwächung zwischen einzelne Näpfe einer Mehrzahl von Näpfen eines Aufnahmeelements und/oder zwischen einzelne Aufnahmeelemente einer Mehrzahl miteinander verbundener Aufnahmeelemente einzubringen. Die Materialschwächung kann beispielsweise als Perforation oder Rille ausgebildet sein und ein Abtrennen eines Napfs oder eines Aufnahmeelements ermöglichen.

Die Formstation umfasst bevorzugt eine Heizvorrichtung zum Erwärmen der Folienbahn und eine Formvorrichtung zum Formen des zumindest einen Napfs in die Folienbahn, wie bereits im Zusammenhang mit dem erfindungsgemäßen Verfahren beschrieben.

Die Beschichtungsstation umfasst vorzugsweise die Beschichtungskammer, in der das Aufnahmeelement mit der Siliziumoxid oder Aluminiumoxid enthaltenen Beschichtung beschichtet wird. Die Beschichtungskammer kann eine Gaszufuhr zum Einführen des Prozessgases in die Beschichtungskammer aufweisen. Die Beschichtungskammer kann mit einer Vakuumquelle zum Erzeugen eines Unterdrucks in der Beschichtungskammer in Fluidverbindung stehen. Weiterhin umfasst die Beschichtungsstation bevorzugt eine Energiequelle, die dazu ausgebildet ist, das Plasma in der Beschichtungskammer zu erzeugen. Die Energiequelle kann zur Erzeugung von Mikrowellen in der Beschichtungskammer ausgebildet sein oder Elektroden umfassen.

Vorzugsweise ist die Beschichtungsstation derart in die Verpackungsmaschine integriert, dass der Träger, in den mindestens ein Aufnahmeelement eingesetzt ist, automatisch die Beschichtungsstation, die Füllstation und die Siegelstation durchlaufen kann.

Weitere Vorteile und Merkmale der vorliegenden Erfindung sind nachfolgend unter Bezugnahme auf die beigefügten Zeichnungen beschrieben.
- Fig. 1: zeigt eine erfindungsgemäße Kontaktlinsenverpackung in einer perspektivischen Ansicht.
- Fig. 2a-d: zeigen eine Kontaktlinsenverpackung und entsprechende Zwischenprodukte während eines erfindungsgemäßen Verfahrens in einer Schnittansicht.
- Fig. 3: zeigt schematisch eine Beschichtungskammer zum Beschichten von Kontaktlinsenverpackungen.
- Fig. 4: zeigt schematisch eine erfindungsgemäße Verpackungsmaschine in einer perspektivischen Ansicht.

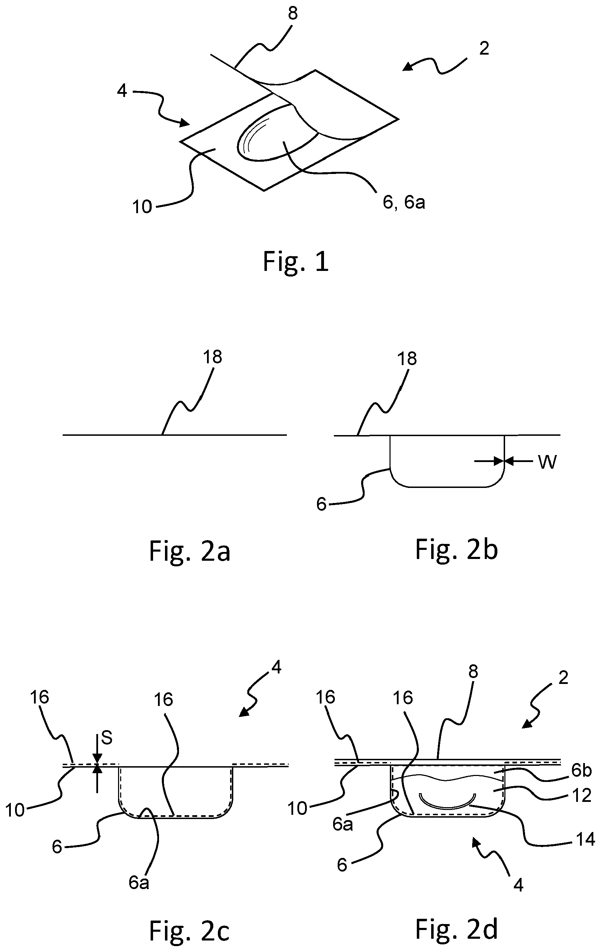

In Fig. 1 ist eine erfindungsgemäße Kontaktlinsenverpackung 2 in einer perspektivischen Ansicht dargestellt. Eine Querschnittsansicht der erfindungsgemäßen Kontaktlinsenverpackung 2 ist in Fig. 2d zu sehen. Die Kontaktlinsenverpackung 2 umfasst ein Aufnahmeelement 4, das zumindest einen Napf 6 aufweist, und eine Deckfolie 8, die mit dem Aufnahmeelement 4 verbunden ist, um den zumindest einen Napf 6 dicht zu verschließen. Zudem weist das Aufnahmeelement 4 einen Flansch 10 auf, der den zumindest einen Napf 6 umgibt und an dem die Deckfolie 8 befestigt ist.

Bevorzugt weist das Aufnahmeelement 4 genau einen Napf 6 auf. Es können mehrere Aufnahmeelemente 4 miteinander verbunden sein, beispielsweise entlang ihrer Längs- und/oder Querseiten. Vorzugsweise sind die Aufnahmeelemente 4 möglichst leicht trennbar miteinander verbunden, beispielsweise mittels eines perforierten Bereichs der Aufnahmeelemente 4 und der Deckfolie 8. Das Aufnahmeelement 4 kann auch eine Mehrzahl von Näpfen 6 aufweisen. Die Beschreibung bevorzugter Ausführungsformen hierin trifft daher im Wesentlichen unabhängig von der Anzahl von Aufnahmeelementen 4 und Näpfen 6 analog auf Ausführungsformen mit einer Mehrzahl von Aufnahmeelementen 4 und/oder einer Mehrzahl von Näpfen 6 zu.

Der zumindest eine Napf 6 dient der Aufnahme eines Kontaktlinsenfluids 12 und einer Kontaktlinse 14, wie in der Querschnittsansicht nach Fig. 2d zu sehen. Um auch bei einer geringen Wandstärke des Aufnahmeelements 4 im Bereich des Napfs 6 eine Diffusion des Kontaktlinsenfluids 12 bzw. von Bestandteilen desselben aus der Kontaktlinsenverpackung 2 heraus zu vermeiden, weist das Aufnahmeelement 4 zumindest im Bereich des Napfs 6 eine Beschichtung 16 auf, die Siliziumoxid oder Aluminiumoxid enthält. Die Beschichtung 16 ist in Fig. 2c und 2d gestrichelt angedeutet. Es versteht sich, dass die Beschichtung 16 bevorzugt durchgängig ausgebildet ist.

Bevorzugt weist zumindest eine Napfinnenseite 6a die Beschichtung 16 auf. Die Napfinnenseite 6a ist die Seite des Napfs 16, die zusammen mit der Deckfolie 8 einen Hohlraum 6b bildet, in dem das Kontaktlinsenfluid 12 und die Kontaktlinse 14 aufgenommen sind. Die Napfinnenseite 6a steht daher in Kontakt mit dem Kontaktlinsenfluid 12 und sollte deswegen vollständig mit der Beschichtung 16 versehen sein, um die erforderliche Barrierewirkung bereitzustellen.

Das Aufnahmeelement 4 kann auch im Bereich außerhalb des Napfs 6 und insbesondere im Bereich des Flansches 10 die Beschichtung 16 aufweisen, wie in Fig. 2c und 2d gezeigt. Es kann aber auch gewünscht sein, dass das Aufnahmeelement 4 außerhalb des Napfs 6 bzw. der Napfinnenseite 6a und insbesondere im Bereich des Flansches 10 keine Beschichtung 16 aufweist, zum Beispiel um die Deckfolie 8 besser an dem Aufnahmeelement 4 befestigen zu können.

Durch die dichtende Wirkung der Beschichtung 16 kann die Wandstärke des Aufnahmeelements 4 gering gehalten werden, während gleichzeitig die Dichtigkeit der Kontaktlinsenverpackung 2 gewährleistet ist. Das Aufnahmeelement 4 kann daher im Bereich des Napfs 6 und vorzugsweise überall eine Wandstärke W aufweisen, die zwischen 0,05 mm und 0,6 mm, mehr bevorzugt zwischen 0,1 mm und 0,5 mm, noch mehr bevorzugt zwischen 0,2 mm und 0,4 mm beträgt.

Die Beschichtung 16 weist vorzugsweise eine Schichtdicke S auf, die zwischen 2 nm und 500 nm, mehr bevorzugt zwischen 10 nm und 250 nm, noch mehr bevorzugt zwischen 20 nm und 80 nm beträgt. In einer besonders bevorzugten Ausführungsform beträgt die Schichtdicke S der Beschichtung 16 zwischen 40 nm und 60 mn oder zwischen 45 nm und 55 nm. Die Beschichtung 16 weist vorzugsweise eine gleichmäßige Schichtdicke S auf, insbesondere auf der Napfinnenseite 6a.

Ein erfindungsgemäßes Verfahren zur Herstellung der Kontaktlinsenverpackung 2 ist nachfolgend beschrieben.

Das Verfahren umfasst zunächst das Bilden des Aufnahmeelements 4, das den zumindest einen Napf 6 aufweist. Um eine Mehrzahl von Kontaktlinsenverpackungen 2 herstellen zu können, können die Verfahrensschritte für jede Kontaktlinsenverpackung 2 wiederholt werden oder jeder Verfahrensschritt wird gleichzeitig für eine Mehrzahl von Aufnahmeelementen 4 durchgeführt und gegebenenfalls anschließend für eine weitere Mehrzahl von Aufnahmeelementen 4 wiederholt. Es versteht sich, dass die folgenden Ausführungen stets für mindestens ein Aufnahmeelement 4 und somit sowohl für ein Aufnahmeelement 4 als auch für eine Mehrzahl von Aufnahmeelementen 4, die parallel oder aufeinanderfolgend hergestellt werden, gelten.

Das Aufnahmeelement 4 kann grundsätzlich mittels Spritzguss oder durch Thermoformen gebildet werden. Wird das Aufnahmeelement 4 durch Spritzguss hergestellt, erhält es dadurch bereits die gewünschte Form mit dem zumindest einen Napf 6, wie beispielsweise in Fig. 2b zu sehen.

Bevorzugt ist jedoch das Bilden des Aufnahmeelements 4 durch Thermoformen. Wie in Fig. 2a und 2b dargestellt, kann das Bilden des Aufnahmeelements 4 das Bereitstellen einer Folienbahn 18 und das Thermoformen des zumindest einen Napfs 6 in die Folienbahn 18 umfassen. Das Thermoformen umfasst wiederum das Erwärmen der Folienbahn 18 und das Tiefziehen des zumindest einen Napfs 16 in der Folienbahn 18. Die Folienbahn 18 kann beispielsweise aus Polypropylen (PP) bestehen und eine Dicke aufweisen, die im Wesentlichen der Wandstärke W des zu bildenden Aufnahmeelements 4, insbesondere des Napfes 16, entspricht. Möglichst effizient ist das Verfahren, wenn gleichzeitig eine Mehrzahl von Näpfen 6 in die Folienbahn 18 geformt wird.

Nachdem der zumindest eine Napf 6 in der Folienbahn 18 ausgebildet wurde, umfasst das Bilden des Aufnahmeelements 4 bevorzugt das Stanzen des Aufnahmeelements 4 aus der Folienbahn 18. Nach dem Stanzen liegen vereinzelte Aufnahmeelemente 4 vor. Dabei kann jedes Aufnahmeelement 4 einen oder mehrere Näpfe 6 aufweisen. Es ist auch denkbar, dass eine Mehrzahl von miteinander verbundenen Aufnahmeelementen 4 ausgestanzt wird.

Das Verfahren umfasst weiterhin das Beschichten des Aufnahmeelements 4 zumindest im Bereich des Napfs 6 mit der Beschichtung 16, die Siliziumoxid oder Aluminiumoxid enthält. Ein entsprechend beschichtetes Aufnahmeelement 4 ist in Fig. 2c zu sehen, wobei die Beschichtung 16 gestrichelt angedeutet ist. Das Beschichten des Aufnahmeelements 4 erfolgt zumindest auf der Napfinnenseite 6a, sodass das Aufnahmeelement 4 zumindest auf der Napfinnenseite 6a die Beschichtung 16 aufweist, wie zuvor beschrieben. Das Beschichten kann auch im Bereich außerhalb des Napfs 6 und insbesondere im Bereich des Flansches 10 erfolgen, wie in Fig. 2c zu sehen ist, oder ausschließlich auf der Napfinnenseite 6a.

Um die Handhabung der filigranen Aufnahmeelemente 4 im weiteren Verfahren zu erleichtern, diese vor Beschädigung zu schützen und das Verfahren möglichst effizient zu gestalten, umfasst das Verfahren bevorzugt das Erfassen des Aufnahmeelements 4 mittels einer Handhabungsvorrichtung und das Einsetzen des erfassten Aufnahmeelements 4 in einen Träger 20 mittels der Handhabungsvorrichtung. Die Handhabungsvorrichtung kann das Aufnahmeelement 4 vorzugsweise nach dem Stanzen direkt aus einer Stanzvorrichtung entnehmen.

Geeignete Handhabungsvorrichtungen sind dem Fachmann beispielsweise als "Pick and Place"-Vorrichtungen bekannt und daher nicht näher beschrieben. Beispielsweise kann die Handhabungsvorrichtung als Greifeinrichtung oder Saugeinrichtung zum Erfassen jeweils eines oder mehrerer Aufnahmeelemente 4 ausgebildet sein.

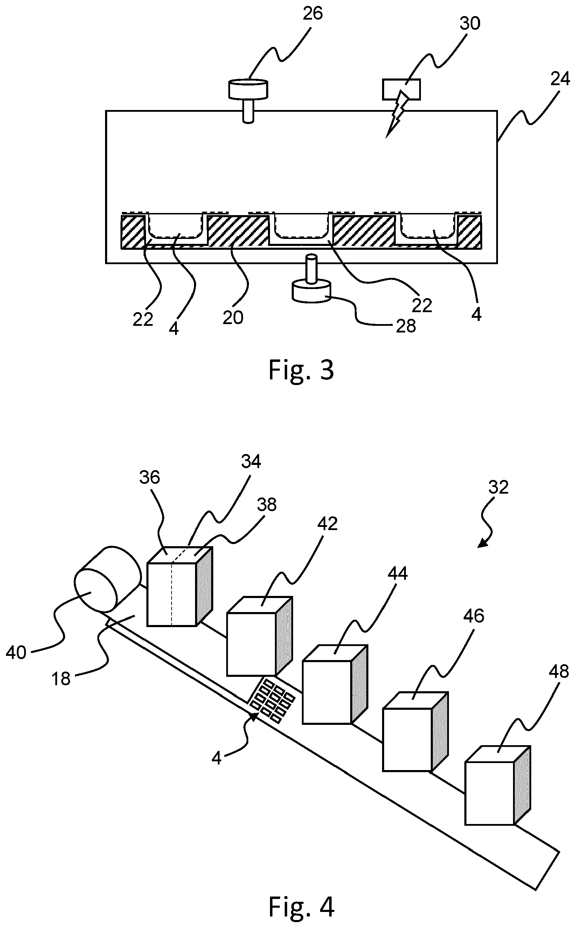

In dem Träger 20, der schematisch in Fig. 3 dargestellt ist, kann das Aufnahmeelement 4 den weiteren Bearbeitungsschritten zugeführt werden. Bevorzugt nimmt der Träger 20 eine Mehrzahl von Aufnahmeelementen 4 gleichzeitig auf. Der Träger 20 umfasst einen Sitz 22, zum Beispiel in Form eines Hofs oder einer Durchgangsöffnung, für jedes aufzunehmende Aufnahmeelement 4 bzw. für jeden aufzunehmenden Napf 16. Das Aufnahmeelement 4 kann dabei derart in dem Träger 20 angeordnet sein, dass der Flansch 10 auf dem Träger 20 aufliegt und der zumindest eine Napf 6 nach oben geöffnet ist, wie in Fig. 3 dargestellt. Das Aufnahmeelement 4 kann aber auch derart auf dem Träger 20 angeordnet sein, dass der Flansch 10 auf dem Träger 20 aufliegt und der zumindest eine Napf 6 nach unten geöffnet ist. Der Sitz 22 ist dann bevorzugt an den Flansch 10 angepasst und nach unten geöffnet, sodass die Napfinnenseite 6a für das Beschichten zugänglich ist. Dadurch liegt das Aufnahmeelement 4 mit den Bereichen des Flansches 10, die an den Napf 6 angrenzen, auf dem Träger 20 auf, und eine Beschichtung dieser Bereiche des Flansches 10 kann unterbunden werden.

Das Beschichten erfolgt bevorzugt in einer Beschichtungskammer 24, die in Fig. 3 schematisch dargestellt ist. Das Verfahren umfasst in diesem Fall vor dem Beschichten des Aufnahmeelements 4 das Anordnen des Aufnahmeelements 4 in der Beschichtungskammer 24 sowie anschließend das Beschichten des Aufnahmeelements 4 in der Beschichtungskammer 24. Das Anordnen des Aufnahmeelements 4 in der Beschichtungskammer 24 erfolgt vorzugsweise durch das Bewegen des Trägers 20 in die Beschichtungskammer 24.

Nach dem Anordnen des Aufnahmeelements 4 in der Beschichtungskammer 24 und vor dem Beschichten des Aufnahmeelements 4 umfasst das Verfahren vorzugsweise das Erzeugen eines Unterdrucks in der Beschichtungskammer 24 und das Einführen eines Prozessgases in die Beschichtungskammer 24.

Hierzu kann die Beschichtungskammer 24 eine Gaszufuhr 26 zum Einführen des Prozessgases in die Beschichtungskammer 24 aufweisen. Die Gaszufuhr 26 ist verschließbar und stellt eine Fluidverbindung zu einem Gastank bereit. Des Weiteren steht die Beschichtungskammer 24 in Fluidverbindung mit einer Vakuumquelle 28 zum Erzeugen des Unterdrucks in der Beschichtungskammer 24.

Im Weiteren umfasst das Verfahren das Erzeugen eines Plasmas in der Beschichtungskammer und dadurch das Erzeugen der Beschichtung 16 auf dem Aufnahmeelement 4. Zum Erzeugen eines Plasmas aus dem Prozessgas weist die Beschichtungskammer 24 eine geeignete Energiequelle 30 auf. Die Energiequelle 30 ist beispielsweise zur Erzeugung von Mikrowellen ausgebildet oder umfasst geeignete Elektroden.

Ist das Aufnahmeelement 4 mit der Beschichtung 16 beschichtet, wird es den weiteren Verfahrensschritten zugeführt, vorzugsweise indem es in dem Träger 20 durch entsprechende Bearbeitungsstationen geführt wird.

Zunächst erfolgt nach dem Beschichten das Füllen des zumindest einen Napfs 6 des Aufnahmeelements 4 mit dem Kontaktlinsenfluid 12 und der Kontaktlinse 14, die in Fig. 2d zu sehen sind. Das Füllen des zumindest einen Napfs 6 des Aufnahmeelements 4 umfasst bevorzugt das Bewegen des Trägers 20 durch eine Füllstation.

Ist der zumindest eine Napf 6 gefüllt, erfolgt das Aufbringen der Deckfolie 8 auf das Aufnahmeelement 4 zum Verschließen des zumindest einen Napfs 6, wie ebenfalls in Fig. 2d dargestellt. Das Aufbringen der Deckfolie 8 umfasst bevorzugt das Kleben oder (Heiß-) Siegeln der Deckfolie 8 an das Aufnahmeelement 4, insbesondere im Bereich des Flansches 10. Das Aufbringen der Deckfolie 8 kann zudem das Bewegen des Trägers 20 durch eine Siegelstation umfassen.

Damit auch die Deckfolie 8 eine ausreichende Barrierewirkung bereitstellt, ist sie vorzugsweise aus einer Aluminium-Verbundfolie gebildet. Solche Deckfolien sind dem Fachmann bekannt und lassen sich einfach mit dem Aufnahmeelement 4 verbinden und zugleich gut zur Entnahme der Kontaktlinse 14 öffnen.

Weist das Aufnahmeelement 4 eine Mehrzahl von Näpfen 6 auf und/oder sind mehrere Aufnahmeelemente 4 miteinander verbunden ausgebildet, kann es gewünscht sein, einzelne Näpfe 6 bzw. Aufnahmeelemente 4 abtrennen zu können. Ist die Deckfolie 8 auf das Aufnahmeelement 4 aufgebracht, kann das Verfahren dann weiterhin das Einbringen einer Materialschwächung, insbesondere einer Perforation oder Rille, zwischen den einzelnen Näpfen 6 eines Aufnahmeelements 4 bzw. zwischen den einzelnen Aufnahmeelementen 4 umfassen.

Unter Bezugnahme auf Fig. 4 ist eine erfindungsgemäße Verpackungsmaschine 32 zum Herstellen der Kontaktlinsenverpackungen 2 beschrieben, die dazu ausgebildet ist, das erfindungsgemäße Verfahren auszuführen und erfindungsgemäße Kontaktlinsenverpackungen 2 herzustellen.

Die Verpackungsmaschine 32 umfasst eine Formstation 34, die dazu ausgebildet ist, den zumindest einen Napf 6 des Aufnahmeelements 4 zu bilden. In dem bevorzugten Ausführungsbeispiel, in dem das Aufnahmeelement 4 durch Thermoformen gebildet wird, umfasst die Formstation 34 eine Heizvorrichtung 36 zum Erwärmen der Folienbahn 18 und eine Formvorrichtung 38 zum Formen bzw. Tiefziehen des zumindest einen Napfs 6 in die Folienbahn 18. Die Heizvorrichtung 36 und die Formvorrichtung 38 sind in Fig. 4 schematisch als Bestandteile der Formstation 34 angedeutet. Bevorzugt wird eine Mehrzahl von Näpfen 6 gleichzeitig geformt.

Die Effizienz des Bildens des zumindest einen Napfs 6 durch Thermoformen kann besonders gut ausgenutzt werden, wenn die Folienbahn 18 auf einer Vorratsrolle 40 bereitgestellt wird. Auf der Vorratsrolle 40 kann die Folienbahn 18 mit großer Länge platzsparend vorgehalten werden. Die Folienbahn 18 lässt sich zudem leicht der Formstation 34 zu führen.

In diesem Ausführungsbeispiel umfasst die Verpackungsmaschine 32 ferner eine optionale Stanzstation 42 zum Stanzen des Aufnahmeelements 4 aus der Folienbahn 18. Bevorzugt wird eine Mehrzahl von Aufnahmeelementen 4 gleichzeitig ausgestanzt. Bevorzugt erfolgt das Stanzen durch die Stanzstation 42 unmittelbar nach dem Formen des zumindest einen Napfs 6 in der Formstation 34. Die Aufnahmeelemente 4 werden dadurch vor dem Beschichten gestanzt, sodass die Unversehrtheit der Beschichtung 16 gewährleistet werden kann. Es ist aber auch denkbar, die Aufnahmeelemente 4 erst nach dem Beschichten zu stanzen. Die Stanzstation 42 wäre dann an entsprechender Stelle in der Verpackungsmaschine 32 anzuordnen.

Geeignete Form- und Stanzstationen 34, 42 sind dem Fachmann auf dem Gebiet der Verpackungsherstellung bekannt und daher nicht im Detail beschrieben.

Nach dem Stanzen liegen die Aufnahmeelemente 4 vereinzelt vor, können aber immer noch mehrere Näpfe 6 aufweisen. Zur schonenden Handhabung werden die Aufnahmeelemente 4 dann bevorzugt mittels der Handhabungsvorrichtung in einen Träger 20 (siehe Fig. 3) eingesetzt und den weiteren Bearbeitungsstationen zugeführt.

Die Verpackungsmaschine 32 umfasst weiterhin eine Beschichtungsstation 44, die zum Beschichten des Aufnahmeelements 4 zumindest im Bereich des zumindest einen Napfs 6 mit der Beschichtung 16, die Siliziumoxid oder Aluminiumoxid enthält, ausgebildet ist. Die Beschichtungsstation 44 kann die Beschichtungskammer 24 und die Energiequelle 30 umfassen, wie sie unter Bezugnahme auf Fig. 3 ausführlich beschrieben sind.

Es ist besonders bevorzugt, dass die Beschichtungsstation 44 in die Verpackungslinie integriert ist, wodurch die Kontaktlinsenverpackungen 2 besonders einfach und effizient herstellbar sind. Insbesondere können die Aufnahmeelemente 4 dann in dem Träger 20 sowohl durch die Beschichtungsstation 44 als auch durch nachfolgende Bearbeitungsstationen geführt werden, ohne dass eine weitere Handhabung oder ein Umsetzen der Aufnahmeelemente 4 erforderlich wäre. Das bedeutet jedoch nicht, dass die Beschichtungsstation 44 in einer Linie mit den übrigen Bearbeitungsstationen angeordnet und ausgerichtet sein muss. So ist zum Beispiel denkbar, dass die Aufnahmeelemente 4 mittels der Handhabungsvorrichtung, die beispielsweise an einem Roboter angebracht ist, von den übrigen Bearbeitungsstationen weg und zur Beschichtungsstation 44 hin versetzt werden. Es ist auch denkbar, dass die Aufnahmeelemente 4 zunächst in den Träger 20 eingesetzt werden und der Träger 20 entsprechend zur Beschichtungsstation 44 geführt oder mittels eines Roboters bewegt wird.

In einer Füllstation 46 der Verpackungsmaschine 32 werden das Kontaktlinsenfluid 12 und die Kontaktliste 14 in jeden Napf 6 gefüllt. Anschließend umfasst die Verpackungsmaschine 32 noch eine Siegelstation 48, die dazu ausgebildet ist, die Deckfolie 8 auf das Aufnahmeelement 4 aufzubringen. Die Füllstation 46 und die Siegelstation 48 können entsprechend bekannten Verpackungsmaschinen zur Herstellung von Kontaktlinsenverpackungen ausgebildet sein und sind daher nicht näher beschrieben.

Sind mehrere Näpfe 6 in einem Aufnahmeelement 4 vorhanden oder mehrere Aufnahmeelemente 4 einstückig miteinander verbunden, können in einer der Siegelstation 48 nachfolgenden Station (nicht dargestellt) Materialschwächungen, insbesondere Perforationen oder Rillen, zwischen einzelnen Näpfen 6 eines Aufnahmeelements 4 bzw. zwischen den einzelnen Aufnahmeelementen 4 eingebracht werden. Auch andere Materialschwächungen anstelle von Perforationen sind möglich.

## Patentansprüche

1. Verfahren zur Herstellung von Kontaktlinsenverpackungen (2), umfassend die folgenden Schritte:
Bilden eines Aufnahmeelements (4), das zumindest einen Napf (6) aufweist;
Beschichten des Aufnahmeelements (4) zumindest im Bereich des zumindest einen Napfs (6) mit einer Beschichtung (16), die Siliziumoxid oder Aluminiumoxid enthält;
Füllen des zumindest einen Napfs (6) des Aufnahmeelements (4) mit einem Kontaktlinsenfluid (12) und einer Kontaktlinse (14); und
Aufbringen einer Deckfolie (8) auf das Aufnahmeelement (4) zum Verschließen des zumindest einen Napfs (6).

2. Verfahren nach Anspruch 1, **dadurch gekennzeichnet, dass** das Bilden des Aufnahmeelements (4) die folgenden Schritte umfasst:
Bereitstellen einer Folienbahn (18); und
Thermoformen des zumindest einen Napfs (6) in die Folienbahn (18).

3. Verfahren nach Anspruch 2, **dadurch gekennzeichnet, dass** das Bilden des Aufnahmeelements (4) weiterhin das Stanzen des Aufnahmeelements (4) aus der Folienbahn (18) vor dem Beschichten des Aufnahmeelements (4) umfasst.

4. Verfahren nach einem der vorangehenden Ansprüche, **dadurch gekennzeichnet, dass** das Aufnahmeelement (4) im Bereich des zumindest einen Napfs (6) eine Wandstärke (W) aufweist, die zwischen 0,05 mm und 0,6 mm, vorzugsweise zwischen 0,1 mm und 0,5 mm, mehr bevorzugt zwischen 0,2 mm und 0,4 mm beträgt.

5. Verfahren nach einem der vorangehenden Ansprüche, **dadurch gekennzeichnet, dass** das Verfahren vor dem Beschichten des Aufnahmeelements (4) weiterhin die Schritte umfasst:
Erfassen des Aufnahmeelements (4) mittels einer Handhabungsvorrichtung; und
Einsetzen des erfassten Aufnahmeelements (4) in einen Träger (20) mittels der Handhabungsvorrichtung.

6. Verfahren nach Anspruch 5, **dadurch gekennzeichnet, dass**
das Füllen des zumindest einen Napfs (6) des Aufnahmeelements (4) das Bewegen des Trägers (20) durch eine Füllstation (46) umfasst; und
das Aufbringen einer Deckfolie (8) auf das Aufnahmeelement (4) das Bewegen des Trägers (20) durch eine Siegelstation (48) umfasst.

7. Verfahren nach einem der vorangehenden Ansprüche, **dadurch gekennzeichnet, dass** das Verfahren vor dem Beschichten des Aufnahmeelements (4) weiterhin das Anordnen des Aufnahmeelements (4) in einer Beschichtungskammer (24) umfasst und das Beschichten des Aufnahmeelements (4) in der Beschichtungskammer (24) erfolgt.

8. Verfahren nach Anspruch 7, **dadurch gekennzeichnet, dass** das Verfahren nach dem Anordnen des Aufnahmeelements (4) in der Beschichtungskammer (24) und vor dem Beschichten des Aufnahmeelements (4) weiterhin die Schritte umfasst:
Erzeugen eines Unterdrucks in der Beschichtungskammer (24); und
Einführen eines Prozessgases in die Beschichtungskammer (24).

9. Verfahren nach Anspruch 8, **dadurch gekennzeichnet, dass** das Beschichten des Aufnahmeelements (4) umfasst:
Erzeugen eines Plasmas in der Beschichtungskammer (24) und dadurch Erzeugen der Beschichtung (16).

10. Verfahren nach einem der vorangehenden Ansprüche, **dadurch gekennzeichnet, dass** die Beschichtung (16) eine Schichtdicke (S) aufweist, die zwischen 2 nm und 500 nm, vorzugsweise zwischen 10 nm und 250 nm, mehr bevorzugt zwischen 20 nm und 80 nm beträgt.

11. Kontaktlinsenverpackung (2) umfassend:
ein Aufnahmeelement (4), das zumindest einen Napf (6) zur Aufnahme eines Kontaktlinsenfluides (12) und einer Kontaktlinse (14) aufweist; und
eine Deckfolie (8), die mit dem Aufnahmeelement (4) verbunden ist, um den zumindest einen Napf (6) zu verschließen;
wobei das Aufnahmeelement (4) zumindest im Bereich des zumindest einen Napfs (6) eine Beschichtung (16) aufweist, die Siliziumoxid oder Aluminiumoxid enthält.

12. Kontaktlinsenverpackung (2) nach Anspruch 11, **dadurch gekennzeichnet, dass** das Aufnahmeelement (4) im Bereich des zumindest einen Napfs (6) eine Wandstärke (W) aufweist, die zwischen 0,05 mm und 0,6 mm, vorzugsweise zwischen 0,1 mm und 0,5 mm, mehr bevorzugt zwischen 0,2 mm und 0,4 mm beträgt.

13. Kontaktlinsenverpackung (2) nach Anspruch 11 oder 12, **dadurch gekennzeichnet, dass** die Beschichtung (16) eine Schichtdicke (S) aufweist, die zwischen 2 nm und 500 nm, vorzugsweise zwischen 10 nm und 250 nm, mehr bevorzugt zwischen 20 nm und 80 nm beträgt.

14. Verpackungsmaschine (32) zum Herstellen von Kontaktlinsenverpackungen (2), wobei die Verpackungsmaschine (32) umfasst:
eine Formstation (34), die dazu ausgebildet ist, zumindest einen Napf (6) eines Aufnahmeelements (4) zu bilden;
eine Beschichtungsstation (44), die dazu ausgebildet ist, das Aufnahmeelement (4) zumindest im Bereich des zumindest einen Napfs (6) mit einer Beschichtung (16) zu beschichten, die Siliziumoxid oder Aluminiumoxid enthält;
eine Füllstation (46), die dazu ausgebildet ist, den zumindest einen Napf (6) des Aufnahmeelements (4) mit einem Kontaktlinsenfluid (12) und einer Kontaktlinse (14) zu befüllen; und
eine Siegelstation (48), die dazu ausgebildet ist, eine Deckfolie (8) auf das Aufnahmeelement (4) zum Verschließen des zumindest einen Napfs (6) aufzubringen.

15. Verpackungsmaschine (32) nach Anspruch 14, **dadurch gekennzeichnet, dass** die Formstation (34) eine Heizvorrichtung (36) zum Erwärmen einer Folienbahn (18) und eine Formvorrichtung (38) zum Formen des zumindest einen Napfs (6) in die Folienbahn (18) umfasst.
